# EUROPÄISCHE PATENTSCHRIFT

(11) **EP 3 637 951 B1**
(45) Veröffentlichungstag und Bekanntmachung des Hinweises auf die Patenterteilung: **07.06.2023**
(21) Anmeldenummer: 19202241.6
(22) Anmeldetag: 09.10.2019
(51) Int. Cl.: H05B 3/26, H05B 3/34

(54) **TEMPERIERVORRICHTUNG UND SYSTEM**
TEMPERING DEVICE AND SYSTEM
DISPOSITIF ET SYSTÈME DE MISE EN TEMPÉRATURE

(30) Priorität: 10.10.2018 DE 102018124985
(43) Veröffentlichungstag der Anmeldung: 15.04.2020
(73) Patentinhaber: STEGO-Holding GmbH, 74523 Schwäbisch Hall (DE)
(72) Erfinder: Dent, Robert, 74523 Schwäbisch Hall (DE); Guilliard, Dietmar, 74535 Mainhardt-Gailsbach (DE); Mangold, Elmar, 73485 Zöbingen, Unterschneidheim (DE)
(74) Vertreter: Meissner Bolte Partnerschaft mbB

(56) Entgegenhaltungen:
- EP-A2- 0 516 112
- DE-A1- 3 042 420
- DE-A1- 3 042 420
- DE-A1-102015 120 183
- US-A1- 2008 067 162

## Beschreibung

Die Erfindung betrifft eine Temperiervorrichtung, insbesondere eine Widerstandsheizvorrichtung, zur Anordnung an einer zu temperierenden Oberfläche, mit wenigstens einem Oberteil, wenigstens einem Unterteil und wenigstens einem ersten Temperierelement. Des Weiteren betrifft die Erfindung ein System, insbesondere einen Schaltschrank oder ein Elektronikgehäuse, mit einer solchen Temperiervorrichtung.

Schaltschränke und Elektronikgehäuse müssen in der Regel aktiv oder passiv temperiert werden. Durch das aktive Beheizen bzw. Kühlen eines solchen Gehäuses wird eine Mindesttemperatur bzw. Maximaltemperatur der elektrischen Komponenten sichergestellt. Auf diese Weise ist es beispielsweise möglich, der Bildung von Kondensfeuchtigkeit innerhalb des Gehäuses vorzubeugen oder eine Überhitzung der Komponenten zu vermeiden. Wird hingegen eine Minimaltemperatur in dem Schaltschrank bzw. Elektronikgehäuse unterschritten, kann die Bildung von Kondensfeuchtigkeit zu Kurzschlüssen in den elektrischen Schaltkreisen führen.

Üblicherweise sind die Komponenten innerhalb eines Schaltschranks bzw. Elektronik-Gehäuses möglichst dicht gepackt angeordnet, um den notwendigen Bauraum zu minimieren und eine kompakte Systemeinheit bereitstellen zu können. Module bzw. Komponenten zur gezielten Temperierung der gesamten Systemeinheit nehmen dabei zusätzlichen Bauraum ein und müssen gleichzeitig eine zuverlässige sowie effiziente Temperierung gewährleisten können.

DE3042420A1 bezieht sich auf einen elektrischen Heizkörper mit ein oder mehreren flachen, quaderförmigen, an gegenüberliegenden Breitflächen mit einer Kontaktierung versehenen Heizelementen, wobei Anschlusselemente für die Heizelemente aus zwei im Wesentlichen ebenen an den Grundriss der Heizelemente im wesentlichen angepassten Kontaktblechen bestehen und die Kontaktbleche mit den dazwischen gelegten Heizelementen lose übereinandergelegt zusammengehalten sind. Die Kontaktbleche sind mit biegsamen Befestigungsfahnen versehen, wobei zwischen den Anlagepunkten der Heizelemente an den Kontaktblechen Durchbrüche in den Kontaktblechen vorgesehen sind.

Unter anderem können Widerstandsheizungen zum Beheizen von Schaltschränken oder dergleichen eingesetzt werden. Ein Heizwiderstand als Bauteil einer Widerstandsheizung ist in seiner einfachsten Ausführung ein Metalldraht, auch Heizleiter genannt. Zumeist ist eine große Drahtlänge erforderlich. Daher werden die Drähte oft in Wendeln oder in Mäanderform angelegt. Eine solche wendelförmige bzw. mäanderförmige Anordnung des Heizleiters macht jedoch einen umfangreichen Bauraum allein für die Heizkomponente innerhalb des Schaltschranks bzw. Elektronikgehäuses notwendig.

Des Weiteren besteht das Problem, dass eine effiziente Wärmeübertragung nur bei einem hinreichenden Flächenkontakt bereitgestellt werden kann. Eine Temperaturerhöhung führt jedoch zu einer Längenausdehnung einer Heizvorrichtung bzw. einzelner Komponenten und damit zu einem Aufwölben. Der notwendige Flächenkontakt zur geeigneten Wärmeübertragung wird in diesem Falle unmöglich. Eine solche Aufwölbung kann dabei als bleibende Verformung auftreten, sodass die Wärmeübertragung reduziert und die Funktion der Heizvorrichtung nicht vollständig gewährleistet ist.

Der Erfindung liegt somit die Aufgabe zugrunde, eine verbesserte Temperiervorrichtung, insbesondere für Schaltschränke und Elektronikgehäuse, anzugeben, die eine einfache, integrale Konstruktion aufweist, einen effizienten Wärmeübergang sicherstellt, eine kostengünstige Herstellung ermöglicht, eine vereinfachte Wartung und Instandhaltung bereitstellt sowie einen minimalen Bauraum einnimmt.

Diese Aufgabe wird durch eine Temperiervorrichtung gemäß dem Anspruch 1 sowie einem System gemäß Anspruch 10 gelöst. Bevorzugte Ausführungsformen sind in den abhängigen Ansprüchen angegeben.

Gemäß der vorliegenden Erfindung ist eine Temperiervorrichtung, insbesondere eine Widerstandsheizvorrichtung, zur Anordnung an einer zu temperierenden Oberfläche, mit wenigstens einem Oberteil, wenigstens einem Unterteil und wenigstens einem ersten Temperierelement, insbesondere einem Heizelement, vorgesehen. Das Oberteil ist einer Oberseite des ersten Temperierelementes gegenüberliegend angeordnet. Das Unterteil ist einer Unterseite des ersten Temperierelementes gegenüberliegend angeordnet, wobei das Unterteil und das Oberteil derart ausgebildet und miteinander im Eingriff sind, sodass mit dem Oberteil und dem Unterteil eine Flächenpressung auf die Oberseite und die Unterseite des ersten Temperierelementes bereitgestellt ist und das Unterteil an die zu temperierende Oberfläche flächenmäßig ankoppelbar ist. Die Temperiervorrichtung weist ein erstes Endkappenelement und ein zweites Endkappenelement auf, wobei das Oberteil, das erste Endkappenelement und das zweite Endkappenelement jeweils an dem Unterteil angeordnet sind, insbesondere befestigt sind. Hierbei ist vorgesehen, dass das zweite Endkappenelement einen Grundkörper und eine Befestigungsspange zur Fixierung des Grundkörpers an der zu temperierenden Oberfläche aufweist, wobei die Befestigungsspange in einer Ausnehmung des Grundkörpers derart angeordnet ist, dass eine Längenänderung der Temperiervorrichtung, insbesondere des Oberteils und/oder des Unterteils, mittels einer elastischen Verformung der Befestigungsspange kompensierbar ist.

Insbesondere ist das Unterteil derart zum Eingriff mit dem Oberteil ausgebildet, sodass mit dem Oberteil und dem Unterteil eine Flächenpressung, insbesondere eine kontinuierliche Flächenpressung in orthogonaler Richtung zu der Oberseite und der Unterseite des ersten Temperierelementes bereitstellbar ist zur flächenmäßigen Ankopplung des Unterteils an die zu temperierenden Oberfläche. Ferner ist die Temperiervorrichtung derart längsverschieblich an der zu temperierenden Oberfläche befestigbar, dass eine Längenänderung der Temperiervorrichtung in Längsrichtung der Temperiervorrichtung aufnehmbar ist.

Die Erfindung basiert auf dem Grundgedanken, dass die Temperiervorrichtung eine mechanische Vorspannung bereitstellt, um eine Ankopplung des Temperierelementes bzw. Heizelementes sowie der Temperiervorrichtung an einen Untergrund bzw. an eine zu temperierende Oberfläche, wie z.B. der Oberfläche oder einer Wandfläche eines Schaltschrankes oder eines Elektronikgehäuses, auch im Falle einer Längenausdehnung sicherzustellen. Auf diese Weise kann ein effizienter Temperaturübergang bis auf eine externe Ankopplungsfläche bzw. Untergrundfläche in Kontakt mit dem Unterteil erzielt werden.

Des Weiteren soll eine platzsparende Konstruktion mittels der erfindungsgemäßen Temperiervorrichtung bereitstellbar sein. Insbesondere sollen das Oberteil und das Unterteil, sowie auch weitere Komponenten der Temperiervorrichtung, derart integral miteinander verbunden bzw. verbindbar sein, dass der Bauraum der Temperaturvorrichtung reduzierbar bzw. minimal ist.

Unter einer Temperiervorrichtung ist im Sinne der vorliegenden Erfindung insbesondere eine Heizvorrichtung zu verstehen. Bevorzugter Weise ist vorgesehen, die Temperiervorrichtung als eine elektrische Heizvorrichtung auszugestalten, beispielsweise als eine elektrische Widerstandsheizvorrichtung. Alternativ ist vorstellbar, die Temperiervorrichtung mit einem Temperierelement auszugestalten, das einen Fluidkreislauf aufweist und mit einem Fluid versorgt wird, um einen Heizeffekt oder einen Kühleffekt zu erzielen.

Gemäß der Erfindung ist das Oberteil der Oberseite des ersten Temperierelementes gegenüberliegend angeordnet bzw. entgegengerichtet, insbesondere entlang einer Ankopplungsfläche des Oberteils. Das Unterteil ist der Unterseite des ersten Temperierelementes gegenüberliegend angeordnet bzw. entgegengerichtet, insbesondere entlang einer Ankopplungsfläche des Unterteils. Somit ist das Temperierelement flächig zwischen dem Oberteil und dem Unterteil der Temperiervorrichtung aufgenommen und verspannbar. Insbesondere kann eine Ankopplung und eine Temperaturübertragung über zumindest einen wesentlichen Teil der Grundfläche des wenigstens einen ersten Temperierelementes erfolgen.

Es ist vorgesehen, dass das Unterteil derart zum Eingriff mit dem Oberteil ausgebildet ist, sodass mit dem Oberteil und dem Unterteil eine Flächenpressung, vorzugsweise eine kontinuierliche bzw. gleichförmige Flächenpressung, in orthogonaler Richtung zu der Oberseite und der Unterseite des ersten Temperierelementes bereitstellbar ist zur flächenmäßigen Ankopplung des Unterteils an die zu temperierende Oberfläche. So ist eine beidseitige bzw. zweiseitige Flächenverspannung des ersten Temperierelementes vorgesehen, sowie das Unterteil an die zu temperierende Oberfläche zweckmäßig angekoppelt wird. Das Oberteil und das Unterteil können zum zweckmäßigen Ineinandergreifen flexibel bzw. reversibel verformbar sein.

Unter einer Flächenpressung bzw. Flächenverspannung ist im Sinne der vorliegenden Erfindung zu verstehen, dass einander gegenüberliegenden Flächen aneinander angekoppelt werden, um Luft- oder Medienspalte zu minimieren und einen Temperaturübergang zu optimieren. Auch im Zuge einer Temperaturerhöhung und einer damit verbundenen Längenausdehnung des Oberteils, des ersten Temperierelementes und/oder des Unterteils ist eine optimale Ankopplung der einander gegenüberliegenden Flächen verfügbar. Die Effizienz der Wärmeübertragung bis auf eine Untergrundfläche, auf der das Unterteil positioniert ist, wird optimiert.

Des Weiteren ist vorgesehen, dass die Temperiervorrichtung derart längsverschieblich an der zu temperierenden Oberfläche befestigbar ist, dass eine Längenänderung der Temperiervorrichtung in Längsrichtung der Temperiervorrichtung aufnehmbar ist. Insbesondere kann die Temperiervorrichtung einen Befestigungsmechanismus zur Anbringung der Temperiervorrichtung an der zu temperierenden Oberfläche aufweisen, der eine Längenänderung in Längsrichtung der Temperiervorrichtung zulässt, ohne dabei eine verformende Kraft auf die Temperiervorrichtung auszuüben.

Unter einer längsverschieblichen Befestigung der Temperiervorrichtung ist im Sinne der Erfindung insbesondere zu verstehen, dass eine Längenänderung der Temperiervorrichtung aufnehmbar bzw. kompensierbar ist. So kann eine zweckmäßige Ankopplung der Temperiervorrichtung, insbesondere des Unterteils, an die zu temperierende Oberfläche bzw. an den Untergrund während des Betriebs der Temperiervorrichtung, und somit auch im Falle einer Längsdehnung der Temperiervorrichtung aufgrund von Temperatureinflüssen, sichergestellt werden.

Nach einer bevorzugten Ausführungsform weist das Oberteil wenigstens ein erstes Spannelement auf, das sich in Längsrichtung des Oberteils erstreckt, sodass das Oberteil beim Ineinandergreifen mit dem Unterteil eine Vorspannung bereitstellt, insbesondere über die gesamte Erstreckung des Unterteils.

Das wenigstens eine erste Spannelement kann sich an einer Innenseite des Oberteils erstrecken. Vorzugsweise können das erste und ein zweites Spannelement symmetrisch an einer Innenseite des Oberteils ausgebildet sein und sich in Längsrichtung des Oberteils erstrecken.

Das wenigstens eine erste Spannelement kann vorzugsweise als ein Materialausschnitt bzw. als eine Materialschwächung entlang des Oberteils ausgebildet sein, insbesondere als eine gezielt einstellbare bzw. ausbildbare Materialschwächung. Eine Steifigkeit bzw. eine Flexibilität des Oberteils ist anhand der Ausbildung und einer Position des wenigstens einen ersten Spannelementes modifizierbar. Die Vorspannung bzw. die Vorspannkraft, die im zusammengesetzten Zustand der Temperiervorrichtung insbesondere von dem Oberteil auf das Unterteil ausgeübt wird, kann anhand des wenigstens einen ersten Spannelements eingestellt werden.

In diesem Sinne ist die anhand der Ausgestaltung des Oberteils grundlegend vorhandene Vorspannkraft des Oberteils mittels des wenigstens einen ersten Spannelementes derart reduzierbar, dass im verwendungsgemäßen Zustand, also insbesondere im Bereich einer vorgesehenen Betriebstemperatur, eine ebene Ankopplungs- und Wärmeübertragungsfläche der Temperiervorrichtung entlang des Unterteils bereitstellbar ist.

Insbesondere das Oberteil kann im Sinne eines Federelementes bzw. einer Druckfeder zur Ausübung einer kontinuierlichen Druckkraft bzw. Flächenpressung auf das Temperierelement und das Unterteil ausgebildet sein. Einem Aufwölben bzw. Abheben des Temperierelementes und/oder der Unterteils im Zuge einer Temperaturhöhung kann auf diese Weise entgegengewirkt und ein Flächenkontakt zur Wärmeübertragung sichergestellt werden.

Anhand der Ausbildung des Spannelementes in Längsrichtung des Oberteils kann die Temperiervorrichtung eine beliebige Gesamtlänge aufweisen. Es wird eine Vorspannung und Ankopplung zur Wärmeübertragung über die gesamte Länge des Ober- und Unterteils erzielt.

Des Weiteren kann das Unterteil wenigstens einen gezielt ausgebildeten Materialausschnitt aufweisen, um eine Verformung bei einer Temperaturerhöhung zu minimieren.

Nach einer bevorzugten Ausführungsform weist das Oberteil eine Oberflächenstruktur auf, insbesondere eine rippenförmige Oberflächenstruktur. So kann eine Vergrößerung der wirksamen Oberflächen zum Wärmeaustausch bzw. zur Temperierung bereitgestellt werden. Im Sinne der vorliegenden Erfindung kann das Oberteil eine beliebige Oberflächenstruktur entlang einer Außenseite aufweisen.

Vorzugsweise können das Oberteil und/oder das Unterteil als ein Strangpressprofil bzw. Extrusionsprofil ausgestaltbar bzw. bereitstellbar sein. Es ist eine einfache und kostengünstige Herstellung des Oberteils und/oder des Unterteils verfügbar.

Gemäß einer weiteren Ausführungsform weist die Temperiervorrichtung ein Erdkontaktelement auf, welches der Unterseite des ersten Temperierelementes verbindbar ist, sodass eine Ankopplung, insbesondere eine elektrisch-thermische Ankopplung, an das erste Temperierelement und das Unterteil bereitstellbar ist.

Indem das Erdkontaktelement eine flächige, elektrische Ankopplung an das Temperierelement bereitstellt, kann eine sichere, elektrische Erdung bzw. Erdverbindung gewährleistet werden. Insbesondere kann ein Stromkabel bzw. ein Anschlusskabel mit dem Erdkontaktelement verbunden werden.

Gemäß einer Ausführungsform ist vorgesehen, dass die Temperiervorrichtung einen Temperatursensor bzw. einen Temperaturwächter aufweist, der mit dem Erdkontaktelement als einem Wärmeleitelement verbunden ist.

In diesem Sinne dient das Erdkontaktelement als ein Strom- und Wärmeleitelement. Das Erdkontaktelement weist somit eine kombinierte, mindestens zweifache Funktionalität für die erfindungsgemäße Temperiervorrichtung auf. Anhand der vorzugsweisen elektrisch-thermischen Ankopplung des Erdkontaktelementes an das erste Temperierelement und das Unterteil, kann sowohl eine elektrische Erdung als auch eine zweckmäßige Temperaturmessung entlang des Erdkontaktelementes ermöglicht werden. Es ist eine vorteilhafte, effiziente Anordnung des Temperatursensors möglich.

In einer bevorzugten Ausführungsform ist vorgesehen, dass an Seitenenden des Oberteils und in Seitenendbereichen des Unterteils jeweils zueinander korrespondierend ausgestalte erste und zweite Verschränkungselemente vorgesehen sind, die sich in Längsrichtung des Oberteils und in Längsrichtung des Unterteils erstrecken, sodass das Oberteil und das Unterteil kraft- und/oder formschlüssig miteinander verbindbar bzw. verschränkbar sind, insbesondere über ihre gesamte Längserstreckung. Alternativ können die Verschränkungselemente nur über einen Teil der Längserstreckung des Oberteils und/oder des Unterteils ausgebildet sein. Im Sinne der Erfindung weisen das Oberteil und das Unterteil zueinander korrespondierend ausgestaltete erste und zweite Verschränkungselemente auf.

Bevorzugter Weise sind das Oberteil und/oder das Unterteil reversibel verformbar bzw. elastisch ausgestaltet, sodass das Oberteil und das Unterteil durch zeitweise Verformung miteinander verbindbar und voneinander lösbar sind. Insbesondere kann anhand der ersten und zweiten Verschränkungselemente in Kombination mit dem ersten Spannelement eine Vorspannung der Temperiervorrichtung bereitgestellt werden, zur zweckmäßigen Ankopplung des innenliegenden Temperierelementes sowie des Unterteils an eine externe Untergrundfläche bzw. die zu temperierende Oberfläche, wie einer Oberfläche eines Schaltschrankes oder dergleichen.

Vorzugsweise können das Oberteil und das Unterteil in eine Raumrichtung lösbar miteinander verbunden sein. So können das Oberteil und das Unterteil in ihre jeweilige Längsrichtung gegenüber einander verschiebbar sein, um eine Verbindung herzustellen oder zu lösen. Des Weiteren können die ersten und/oder die zweiten Verschränkungselemente durch eine wenigstens abschnittsweise rotatorische Bewegung miteinander verbindbar sein.

Das Unterteil stellt ein zentrales Bauelement der Temperiervorrichtung dar. Das Oberteil, das erste Endkappenelement und/oder das zweite Endkappenelement können zum Eingriff in das Unterteil als zentrale Komponente ausgebildet sein. Es liegt eine integrale Konstruktion der Temperiervorrichtung vor.

Die Endkappenelemente können an dem Unterteil angeordnet werden bevor das Oberteil angebracht wird. Somit ist ein Schutz vor einer möglichen Berührung von spannungs- bzw. stromführenden Bauteilen bei dem Zusammensetzen der Temperiervorrichtung gegeben. Des Weiteren ermöglicht die seitliche Anordnung der Endkappenelemente an dem Unterteil, dass die Temperiervorrichtung mittels dem Oberteil und dem Unterteil beliebig lang bzw. groß ausgestaltet werden kann.

Des Weiteren können auch strom- bzw. spannungsführende Elemente, wie ein Erdkontaktelement und/oder ein Temperatursensor, durch das Unterteil der Temperiervorrichtung aufgenommen sein.

Gemäß einer weiteren bevorzugten Ausführungsform ist vorgesehen, dass das Oberteil und das Unterteil zwischen dem ersten und zweiten Endkappenelement angeordnet sind, zur Ausbildung eines Gehäuses für das erste Temperierelement.

Die Anordnung des Oberteils, des Unterteils, des ersten Endkappenelementes und des zweiten Endkappenelementes stellt in diesem Sinne einen im Wesentlichen geschlossenen Hohlraum zur Aufnahme und zweckmäßigen Ankopplung des Temperierelementes bzw. des Heizelementes bereit. Die Temperiervorrichtung ist im Wesentlichen modular zusammensetzbar bzw. aufgebaut.

Nach einer Ausführungsform weist das erste Endkappenelement wenigstens ein erstes Rastelement auf, wobei das zweite Endkappenelement wenigstens ein zweites Rastelement aufweist und das Unterteil wenigstens ein erstes Aufnahmeelement und wenigstens ein zweites Aufnahmeelement aufweist, wobei das erste und zweite Rastelement jeweils korrespondierend zu dem ersten und zweiten Aufnahmeelement ausgebildet sind, zur kraft- und/oder formschlüssigen Verbindung des Unterteils mit dem ersten und zweiten Endkappenelement.

Insbesondere können das erste bzw. zweite Rastelement als Rasthaken, Rastnase oder dergleichen ausgebildet sein, zum Eingriff in das erste bzw. zweite Aufnahmeelement an dem Unterteil. Des Weiteren können das erste Rastelement in Kombination mit dem ersten Aufnahmeelement und das zweite Rastelement in Kombination mit dem zweiten Aufnahmeelement unterschiedlich ausgebildet sein.

So kann die Ausnehmung in dem Grundkörper größer ausgebildet sein als die Befestigungsspange bzw. eine Dicke der Befestigungsspange. Des Weiteren kann die Befestigungsspange in einem Ausgangszustand der Temperiervorrichtung, also vor der Verwendung der Temperiervorrichtung, mittig oder an einem Ende der Ausnehmung in dem Grundkörper angeordnet sein, sodass eine Längsausdehnung der Temperiervorrichtung im Betriebszustand aufnehmbar bzw. absorbierbar ist, insbesondere in Form einer plastischen Verformung der Befestigungsspange. Im Betriebszustand kann somit eine ebene Auflagefläche der Temperiervorrichtung sichergestellt werden.

Gemäß einer weiteren Ausführungsform ist entlang der Ausnehmung des Grundkörpers wenigstens ein Nasenelement ausgebildet, zur Übertragung einer Spannkraft zwischen dem Grundkörper und der Befestigungsspange in Längsrichtung der Temperiervorrichtung. Insbesondere können zwei Nasenelemente symmetrisch verteilt entlang der Ausnehmung des Grundkörpers verteilt angeordnet sein.

Anhand der Nasenelement kann bei einer Längenänderung der Temperiervorrichtung, insbesondere bei einer auftretenden Verlängerung der Temperiervorrichtung, die resultierende Spannkraft von den Nasenelementen auf die Befestigungsspange übertragen und in eine elastische Verformung der Befestigungsspange umgewandelt werden. Auf diese Weise kann die Befestigungsspange die Längenänderung der Temperiervorrichtung, insbesondere des Oberteils und/oder des Unterteils, aufnehmen bzw. kompensieren.

In einem nebengeordneten Aspekt der Erfindung ist ein System vorgesehen, insbesondere einen Schaltschrank oder ein Elektronikgehäuse, mit einer Temperiervorrichtung gemäß einem der vorhergehenden Ansprüche.

In diesem Sinne kann das System beispielsweise ein Schaltschrank mit elektrischen bzw. elektronischen Komponenten sein, der die erfindungsgemäße Temperiervorrichtung aufweist, vorzugsweise um eine Mindesttemperatur bzw. Minimaltemperatur in dem Schaltschrank sicherzustellen. Auf diese Weise kann die Bildung von Kondensfeuchtigkeit innerhalb des Schaltschrankes vermieden und die Funktionalität der Komponenten des Schaltschrankes sichergestellt werden. Es ist eine vorteilhafte, gezielte Temperierung bereitstellbar.

Nachfolgend wird die Erfindung unter Bezugnahme auf die beigefügten Zeichnungen hinsichtlich weiterer Merkmale und Vorteile näher erläutert.

Hierbei zeigen:
- Fig. 1: eine perspektivische Ansicht eines ersten Ausführungsbeispiels einer erfindungsgemäßen Temperiervorrichtung;
- Fig. 2: eine perspektivische Innendarstellung des ersten Ausführungsbeispiels einer erfindungsgemäßen Temperiervorrichtung nach Fig. 1;
- Fig. 3: eine perspektivische Schnittdarstellung des ersten Ausführungsbeispiels gemäß Fig. 1.
- Fig. 4: eine perspektivische Schnittdarstellung des ersten Ausführungsbeispiels gemäß Fig. 1; und
- Fig. 5a: eine perspektivische Detaildarstellung des ersten Ausführungsbeispiels gemäß Fig. 1;
- Fig. 5b: eine weitere perspektivische Detaildarstellung des ersten Ausführungsbeispiels gemäß Fig. 1;
- Fig. 6: eine weitere perspektivische Detailansicht des ersten Ausführungsbeispiels gemäß Fig. 1;
- Fig. 7: eine perspektivische Ansicht eines zweiten Ausführungsbeispiels der erfindungsgemäßen Temperiervorrichtung; und
- Fig. 8: eine perspektivische Schnittansicht des zweiten Ausführungsbeispiels gemäß Fig. 7.

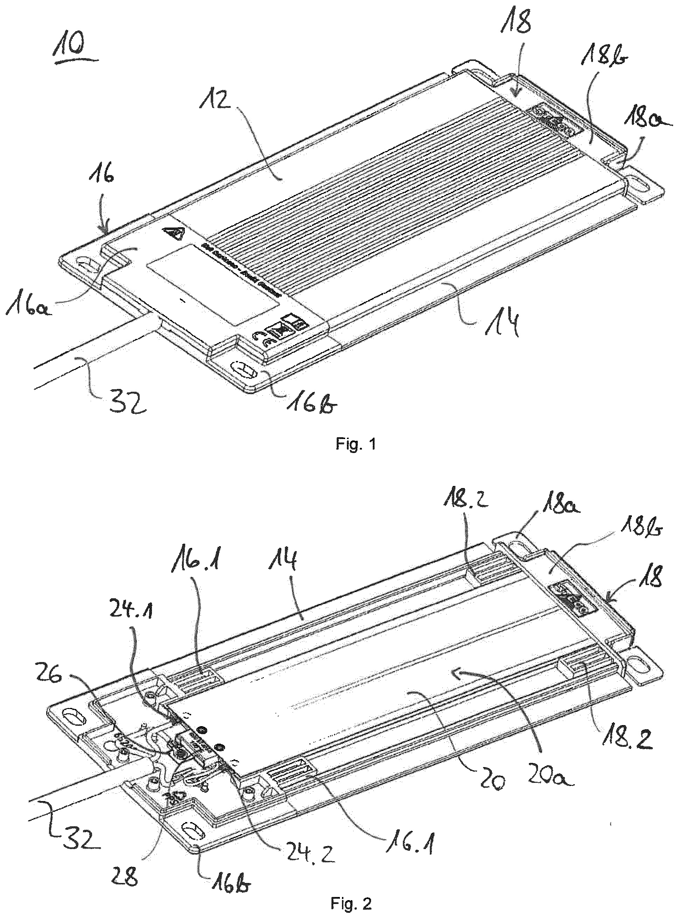

Fig. 1 zeigt eine perspektivische Ansicht eines ersten Ausführungsbeispiels einer erfindungsgemäßen Temperiervorrichtung 10.

Die Temperiervorrichtung 10 ist mit einem Oberteil 12 und einem Unterteil 14 gezeigt, die aufeinander angeordnet sind. An den längsseitigen Enden des Oberteils 12 bzw. Unterteils 14 sind ein erstes Endkappenelement 16 und ein zweites Endkappenelement 18 einander gegenüberliegend angeordnet. Das Oberteil 12, das Unterteil 14, das erste Endkappenelement 16 und das zweite Endkappenelement 18 bilden ein im Wesentlichen geschlossenes Gehäuse aus.

Das erste Endkappenelement 16 weist ein Oberteil 16a und ein Unterteil 16b auf, die aufeinander aufgesetzt und miteinander verbunden sind. In dem ersten Endkappenelement 16 können weitere Komponenten der Temperiervorrichtung 10, wie ein Erdkontaktelement 26 oder ein Temperatursensor 28, angeordnet werden. Das zweite Endkappenelement 18 ist gemäß Fig. 1 ebenfalls mehrteilig, insbesondere mit einer zusätzlichen, einsetzbaren Befestigungsspange 18a und einem Grundkörper 18b ausgebildet. Alternativ kann das zweite Endkappenelement 18 einteilig ausgebildet sein.

Des Weiteren läuft in Längsrichtung der Temperiervorrichtung 10 ein elektrisches Kabel bzw. Anschlusskabel 32 in das erste Endkappenelement 16 ein. So kann die Temperiervorrichtung 10 mit elektrischem Strom versorgt werden, beispielsweise bei Ausbildung der erfindungsgemäßen Temperiervorrichtung 10 als eine elektrische Widerstandsheizung. Auch können das erste Endkappenelement 16 und/oder weitere Bauteile der Temperiervorrichtung 10 derart ausgebildet sein, dass eine Zugentlastung für das Anschlusskabel 32 bereitstellbar ist.

Darüber hinaus sind an dem ersten und zweiten Endkappenelement 16; 18 jeweils zwei Fixierungsbohrungen zur Befestigung der Temperiervorrichtung 10 vorgesehen, z.B. innerhalb eines Schaltschrankes bzw. eines Elektronikgehäuses. Die Fixierungsbohrungen können in der Befestigungsspange 18a des zweiten Endkappenelements 18 ausgebildet sein. Die Fixierungsbohrungen können gemäß Fig. 1 als längsförmige Nuten jeweils in einer Ecke der Temperiervorrichtung 10 ausgebildet sein.

Vorzugsweise können die Fixierungsbohrungen an wenigstens einem der Endkappenelemente 16; 18 quer zur Längserstreckung der Temperiervorrichtung 10 ausgebildet sein und an dem gegenüberliegenden Endkappenelement 16; 18 in Längsrichtung der Temperiervorrichtung 10 ausgebildet sein, insbesondere bei einteiliger Ausgestaltung des ersten und/oder zweiten Endkappenelementes 16; 18. Somit ist die Temperiervorrichtung 10 längsverschieblich befestigbar, sodass eine Längenänderung aufnehmbar bzw. kompensierbar ist.

Fig. 2 zeigt eine perspektivische Innendarstellung des ersten Ausführungsbeispiels einer erfindungsgemäßen Temperiervorrichtung 10 nach Fig. 1.

Gemäß Fig. 2 weist die Temperiervorrichtung 10 ein erstes Temperierelement 20 mit einer Oberseite 20a auf. Das erste Temperierelement 20 ragt aus dem ersten Endkappenelement 16 heraus, über das Oberteil 12 bzw. Unterteil 14 hinweg, bis in das zweite Endkappenelement 18 hinein.

Auf dem Unterteil 16b des ersten Endkappenelementes 16 ist das Anschlusskabel 32 angeordnet, zur elektrischen Versorgung bzw. Verbindung insbesondere des ersten Temperierelementes 20. Des Weiteren sind an dem ersten Temperierelement 20 ein erster elektrischer Anschluss 24.1 und ein zweiter elektrischer Anschluss 24.2 vorgesehen, zur elektrischen Verbindung mit dem Anschlusskabel 32. An dem ersten Temperierelement 20 ist ferner ein Erdkontaktelement 26 angeordnet, das in Verbindung mit dem Kabel bzw. Anschlusskabel 32 steht.

Das Unterteil 16b des ersten Endkappenelementes 16 weist zwei erste Rastelemente 16.1 auf. Die zwei ersten Rastelemente 16.1 erstrecken sich seitlich des ersten Temperierelementes 20 von dem Unterteil 16b des ersten Endkappenelementes 16 in das Unterteil 14 hinein, zur Verbindung des ersten Endkappenelementes 16 mit dem Unterteil 14. Des Weiteren weist das zweite Endkappenelement 18 zwei zweite Rastelemente 18.2 auf, die sich beidseitig des ersten Temperierelementes 20 in das Unterteil 14 hineinerstrecken, zur Verbindung des zweiten Endkappenelementes 18 mit dem Unterteil 14. Gemäß Fig. 2 sind die ersten und zweiten Rastelemente 16.1; 18.2 identisch ausgebildet.

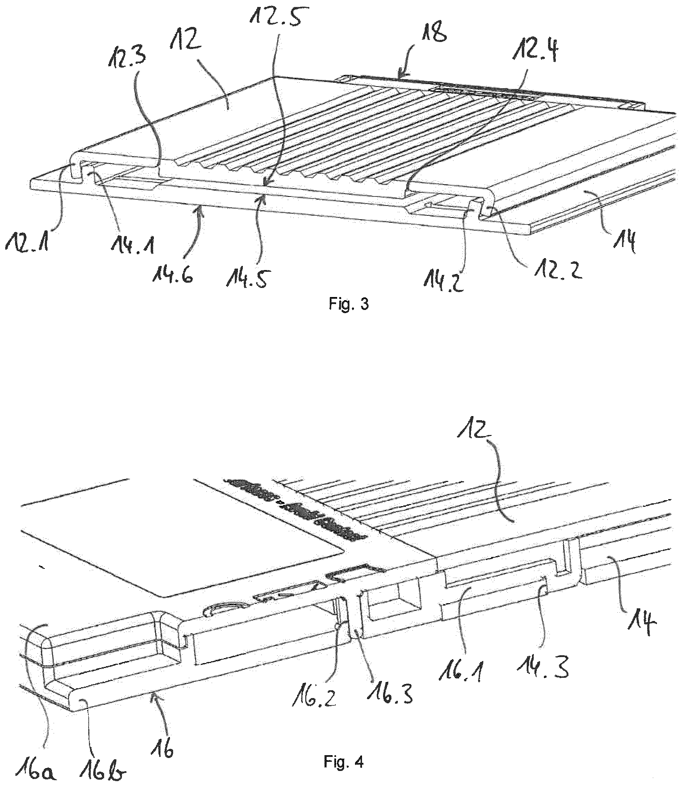

Fig. 3 zeigt eine perspektivische Schnittdarstellung des ersten Ausführungsbeispiels gemäß Fig. 1.

Das Oberteil 12 weist eine Ankopplungsfläche 12.5 und das Unterteil 14 eine gegenüberliegende Ankopplungsfläche 14.5 zur Ankopplung des ersten Temperierelementes 20 auf. Es kann eine zweckmäßige Verspannung des wenigstens einen ersten Temperierelementes bzw. Heizelements 20 (in Fig. 3 nicht gezeigt) zwischen den Ankopplungsflächen 12.5; 14.5 erfolgen. Die Ankopplungsflächen 12.5; 14.5 ermöglichen eine gleichmäßige, kontinuierliche Flächenpressung bzw. Flächenverspannung über einen wesentlichen Teil der Ober- und Unterfläche 20a; 20b des ersten Temperierelementes 20.

Das Oberteil 12 der Temperiervorrichtung ist kraft- und/oder formschlüssig mit dem Unterteil 14 verbunden. An Seitenenden des Oberteils 12 sind ein erstes und ein zweites Verschränkungselement 12.1; 12.2 ausgebildet, wobei an Seitenendbereichen des Unterteils 14 dazu korrespondierende erste und zweite Verschränkungselemente 14.1; 14.2 vorgesehen sind. Die ersten Verschränkungselemente 12.1; 14.1 und die zweiten Verschränkungselemente 12.2; 14.2 sind jeweils über die gesamte Länge des Ober- und Unterteils 12; 14 zum Eingriff ineinander ausgebildet. Es wird eine Verbindung im Sinne eines Schnappeffektes bereitgestellt.

Gemäß Fig. 3 sind das erste und zweite Verschränkungselement 12.1; 12.2 des Oberteils 12 identisch zueinander ausgebildet, insbesondere als nach innen abgewinkelte Seitenenden mit einem Winkel von ca. 100 Grad gegenüber der Horizontalen. Ebenso sind die dazu korrespondierenden ersten und zweiten Verschränkungselemente 14.1; 14.2 des Unterteils 14 identisch ausgebildet, insbesondere als nasenförmige Wandabschnitte, die zu den Seitenenden des Unterteils 14 hin in einem Winkel von ca. 100-110 Grad gegenüber der Horizontalen geneigt sind. Die Ausrichtung gegenüber der Vertikalen bzw. Horizontalen ist auf die Darstellung in Fig. 3 bezogen und im zweckmäßigen Gebrauch von der konkreten Ausrichtung der Temperiervorrichtung 10 abhängig.

Vorzugsweise sind die Verschränkungselemente 12.1; 12.2; 14.1; 14.2 des Oberteils 12 und des Unterteils 14 derart ausgebildet, dass eine Vorspannung der Temperiervorrichtung 10 möglich ist. Dabei können das Oberteil 12 und/oder das Unterteil 14 wenigstens teilweise reversibel verformbar sein.

Des Weiteren weist das Oberteil ein erstes und ein zweites Spannelement 12.3; 12.4 in Form von Spannnuten 12.3; 12.4 auf. Die Spannnuten 12.3; 12.4 sind seitlich der Ankopplungsfläche 12.5 des Oberteils 12 als gezielte Materialausnehmungen bzw. Materialschwächungen ausgebildet. Insbesondere sind die Spannelemente bzw. Spannnuten 12.3; 12.4 symmetrisch in Form eines Kreisausschnitts über ca. 270 Grad ausgebildet und erstrecken sich in Längsrichtung des Oberteils 12.

Mittels der ersten und zweiten Spannnut 12.3; 12.4 ist es möglich, bei Verbindung des Oberteils 12 mit dem Unterteil 14 eine spezifische Spannkraft zu erzeugen, die die Temperiervorrichtung 10 mechanisch vorspannt. So kann eine kontinuierliche Flächenpressung auf das erste Temperierelement bzw. Heizelement 20 entlang der Ankopplungsflächen 12.5; 14.5 ausgeübt werden.

Ferner kann die Temperiervorrichtung 10 derart vorgespannt werden, dass eine Längenausdehnung bei einer Temperaturerhöhung kompensiert und eine Unterseite 14.6 des Unterteils 14 stets auf dem Untergrund angekoppelt ist.

Darüber hinaus ist über wenigstens einen Teil einer Außenfläche des Oberteils 12 eine Oberflächenstruktur ausgebildet. Insbesondere ist die Struktur in Form von Stegen mit angestellten Flanken vorgesehen, wobei die Stege in Längsrichtung des Oberteils 12 verlaufen. Somit kann die effektive Oberfläche zur Wärmeübertragung zweckmäßig vergrößert werden.

Fig. 4 zeigt eine perspektivische Schnittdarstellung des ersten Ausführungsbeispiels gemäß Fig. 1.

Das Oberteil 16a des ersten Endkappenelementes 16 weist wenigstens ein Zapfenelement 16.3 auf. Das Zapfenelement 16.3 kann mit einem runden oder einem mehreckigen Querschnitt vorgesehen sein. Das Unterteil 16 ist mit wenigstens einer dazu korrespondierenden Aufnahmeöffnung 16.2 ausgebildet. Insbesondere kann die Aufnahmeöffnungen 16.2 einen mehreckigen, vorzugsweise sechseckigen, Querschnitt aufweisen. Auf diese Weise kann das Zapfenelement 16.3 in die Aufnahmeöffnungen 16.2 eingreifen und eine zweckmäßige Verpressung stattfinden, zur kraft- und/der formschlüssigen Verbindung des Oberteils 16a mit dem Unterteil 16b des ersten Endkappenelementes 16.

Des Weiteren schließen das Oberteil 16a und das Unterteil 16b bündig mit dem Oberteil 12 und dem Unterteil 14 ab.

Ferner ist in Fig. 4 eines der zwei ersten Rastelemente 16.1 des ersten Endkappenelementes 16 im Detail gezeigt. Das erste Rastelement 16.1 ist zum Eingriff in ein korrespondierendes erstes Aufnahmeelement 14.3 des Unterteils vorgesehen, insbesondere in Form eines Rasthakens. Die ersten Rastelemente 16.1 sind einstückig mit dem Unterteil 16b des ersten Endkappenelementes 16 ausgebildet.

Vorzugsweise kann ein erstes Aufnahmeelement 14.3 des Unterteils 14, ebenso wie das zweite Aufnahmeelement 14.4, in Form einer rechteckförmigen Aussparung durch einen nachträglichen Prozessschritt an dem Unterteil 14 ausgestaltbar sein. Auf diese Weise kann das Unterteil 14, ebenso wie das Oberteil 12, in seiner Grundform als ein Strangpressprofil bzw. ein Extrusionsprofil bereitstellbar sein.

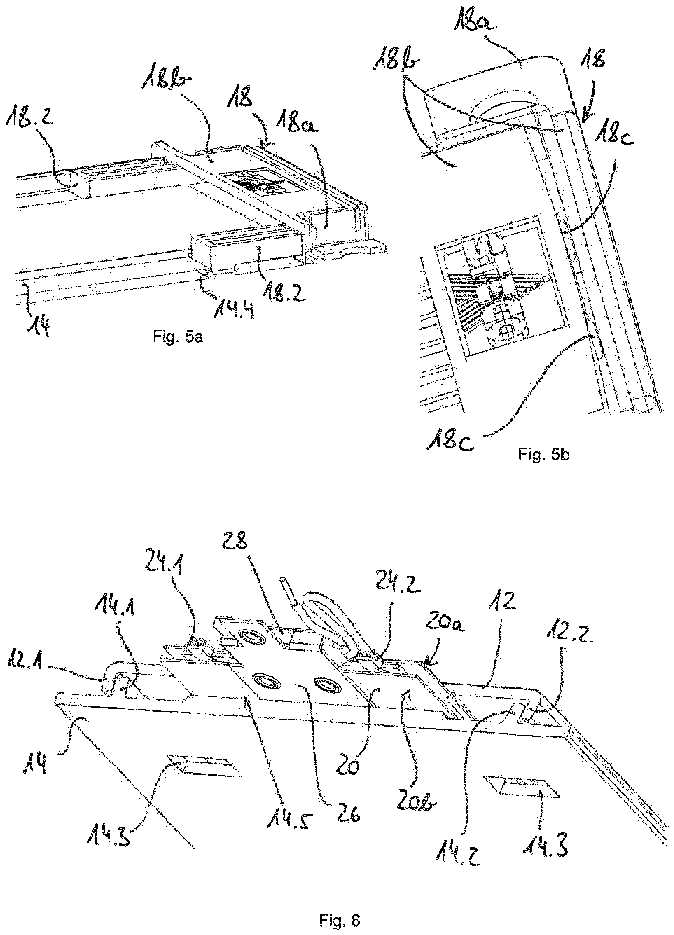

Fig. 5a zeigt eine perspektivische Detaildarstellung des ersten Ausführungsbeispiels gemäß Fig. 1.

Gemäß Fig. 5a weist das zweite Endkappenelement 18 zweite Rastelemente 18.2 auf. Die zweiten Rastelemente 18.2 sind identisch mit den ersten Rastelementen 16.1 des ersten Endkappenelements 16 ausgebildet und greifen in zweite Aufnahmeelemente 14.4 des Unterteils ein.

Des Weiteren kann das zweite Endkappenelement 18 gemäß Fig. 5a mehrteilig ausgebildet sind, insbesondere mit einer einlegbaren bzw. einklemmbaren Befestigungsspange 18a und einem Grundkörper 18b. In der Befestigungsspange 18a sind Fixierungsbohrungen zur zweckmäßigen Befestigung der Temperiervorrichtung 10 an einer externen Untergrundfläche vorgesehen.

Der Grundkörper 18b des zweiten Endkappenelements 18 weist eine Ausnehmung auf, in der die Befestigungsspange 18a angeordnet bzw. aufgenommen ist. Dabei ist die Ausnehmung bzw. die Aussparung des Grundkörpers 18b in Längsrichtung der Temperiervorrichtung 10 größer ausgestaltet als die Befestigungsspange 18a bzw. eine Dicke der Befestigungsspange 18a.

So kann eine Längsausdehnung der Temperiervorrichtung 10, insbesondere des Oberteils 12 bzw. des Unterteils 18, entlang der Ausnehmung des Grundkörpers 18b kompensiert werden, während die Befestigungsspange 18a die Fixierung der Temperiervorrichtung 10 an der externen Untergrundfläche bzw. einer zu temperierenden Oberfläche sicherstellt. Die Befestigungsspange 18a stellt in Verbindung mit der Ausnehmung des Grundkörpers 18b eine Ausgleichskomponente für eine Längenausdehnung der Temperiervorrichtung 10, insbesondere des Oberteils 12 bzw. des Unterteils 14, dar.

In Fig. 5b ist eine weitere perspektivische Detaildarstellung des ersten Ausführungsbeispiels gemäß Fig. 1 gezeigt.

Insbesondere zeigt Fig. 5b die Anordnung der Befestigungsspange 18a in der Ausnehmung des Endkappenelements 18. Entlang der Ausnehmung des Endkappenelementes 18 bzw. des Grundkörpers 18b sind zwei Nasenelemente 18c angeordnet, die sich in Richtung der Befestigungsspange 18a erstrecken.

Insbesondere kann anhand der Nasenelemente 18c eine Kraftübertragung von dem Grundkörper 18b auf die Befestigungsspange 18a erfolgen. Im Zuge einer Längsdehnung bzw. einer Längenänderung der Temperiervorrichtung 10, insbesondere des Oberteils 12 und/oder des Unterteils 14, übertragen die Nasenelemente 18c eine Kraft auf die Befestigungsspange 18a, sodass eine Verformung der Befestigungsspange 18a eintritt. Auf diese Weise ist die Längenänderung der Temperiervorrichtung 10 aufnehmbar bzw. kompensierbar.

Des Weiteren sind die Nasenelemente 18c gemäß Fig. 1 halbrundförmig ausgebildet und symmetrisch zu einer Längsachse der Temperiervorrichtung 10 entlang der Ausnehmung des Grundkörpers 18b angeordnet.

Fig. 6 zeigt eine weitere perspektivische Detailansicht des ersten Ausführungsbeispiels gemäß Fig. 1.

An der Unterseite 20b des ersten Temperierelementes 20 ist gemäß Fig. 6 das Erdkontaktelement 26 angekoppelt. Das Erdkontaktelement 26 ragt als eine Platte unter dem ersten Temperierelement 20 hervor und weist eine Anschlussnase zur Verbindung mit dem Anschlusskabel 32 auf. Auf dem Erdkontaktelement 26 ist ferner der Temperatursensor bzw. Temperaturwächter 28 angeordnet. Somit dient das Erdkontaktelement 26 auch als Wärmeleitelement für den Temperatursensor 28 und weist in diesem Sinne eine kombinierte Funktionalität auf.

Das erste Temperierelement 20 kann mehrschichtig aufgebaut sein. Des Weiteren können im Sinne der Erfindung mehrere Temperierelemente 20 übereinandergestapelt und/oder nebeneinander angeordnet vorgesehen sein.

Des Weiteren ist in Fig. 6 die Ankopplungsfläche 14.5 des Unterteils zur verspannten, flächigen Ankopplung der Unterseite 20b des ersten Temperierelementes 20 erkennbar, um einen optimierten Wärmeübergang bereitzustellen.

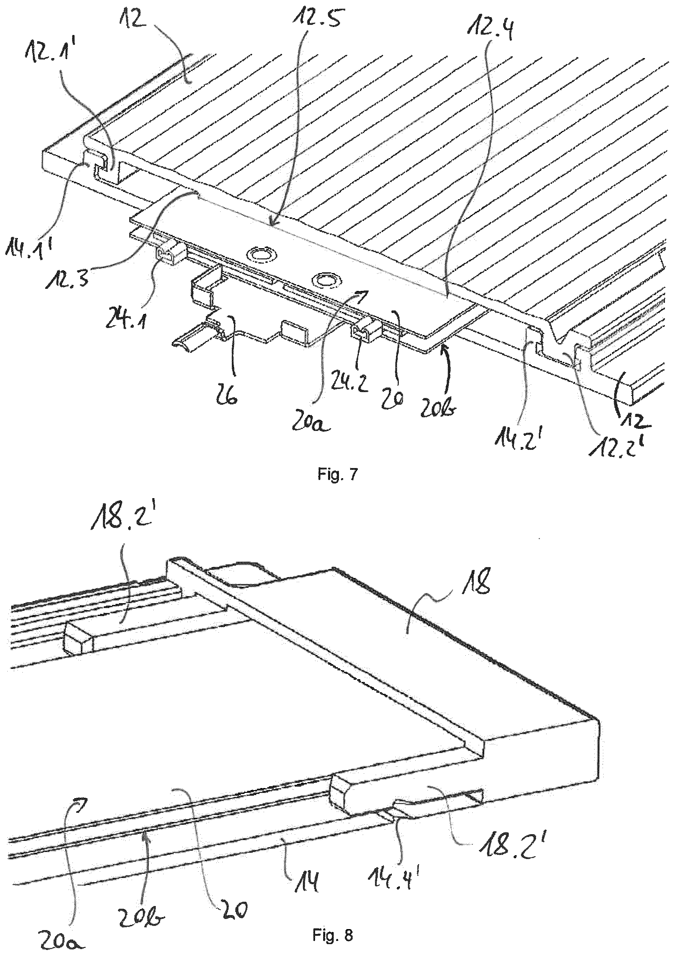

In Fig. 7 ist eine perspektivische Ansicht eines zweiten Ausführungsbeispiels der erfindungsgemäßen Temperiervorrichtung 10 dargestellt.

Das Oberteil 12 und das Unterteil 14 weisen jeweils korrespondierend zueinander ausgestaltete erste Verschränkungselemente 12.1'; 14.1' und zweite Verschränkungselemente 12.2'; 14.2' auf. Gemäß Fig. 7 sind die ersten Verschränkungselemente 12.1'; 14.1' derart L-förmig ausgebildet, dass ein gegenseitiger Eingriff möglich ist. Insbesondere können die ersten Verschränkungselemente 12.1'; 14.1' im Sinne einer teilweise rotatorischen Bewegung oder einer rein translatorischen Verschiebung, quer zur Längserstreckung des Oberteils 12 und Unterteils 14, miteinander in Eingriff gebracht werden.

Das zweite Verschränkungselement 14.2' des Unterteils 14 ist im Wesentlichen als eine U-förmige Nut ausgestaltet. Das zweite Verschränkungselement 12.2' des Oberteils 12 kann mit einem rechteckigen Querschnitt in das zweite Verschränkungselement 14.2' des Unterteils 14 eingebracht und dort verklemmt werden. Anhand einer V-förmigen Nut des Oberteils 12, an einer Oberseite des zweiten Verschränkungselementes 12.2', kann eine reversible Verformung zur Verklemmung der zweiten Verschränkungselemente 12.2'; 14.2' bereitgestellt werden.

Darüber hinaus ist aus Fig. 7 entnehmbar, dass das Oberteil 12 entlang der Ankopplungsfläche 12.5 mit der Oberseite 20a des ersten Temperierelementes 20 in Kontakt kommt, um eine Flächenpressung auf einen wesentliche Teil der Oberseite 20a des ersten Temperierelementes 20 aufzubringen. Selbiges gilt für die Ankopplungsfläche 14.5 des Unterteils 14 in Kontakt mit der Unterseite 20b des Temperierelementes 20.

Des Weiteren weist das Oberteil 12 entlang der Außenseite über nahezu die gesamte Breite eine Oberflächenstruktur im Form von alternierend ansteigenden und abfallenden Flanken auf, die sich in weitwinkeligen Kanten aneinander anschließen.

Fig. 8 zeigt eine perspektivische Schnittansicht des zweiten Ausführungsbeispiels gemäß Fig. 7.

Nach Fig. 8 sind die zweiten Rastelemente 18.2' des zweiten Endkappenelementes 18 in Form von Rasthaken ausgebildet, die einen nasenförmigen bzw. dreieckförmigen Ausschnitt aufweisen. Insbesondere sind die zweiten Rastelemente 18.2' einstückig mit dem zweiten Endkappenelement 18 ausgebildet. Das Unterteil 14 ist mit einem korrespondierend ausgestalteten, zweiten Aufnahmeelement 14.4' in Form einer dreieckförmigen Nase vorgesehen, zum Eingriff in das zweite Rastelemente 18.2'. Vorzugsweise sind die ersten Rastelemente (in Fig. 8 nicht gezeigt) und die zweiten Rastelemente 18.2' sowie die ersten Aufnahmeelemente (in Fig. 8 nicht gezeigt) und die zweiten Aufnahmeelemente 14.4'identisch ausgebildet.

Anhand der erfindungsgemäßen Temperiervorrichtung 10 kann eine integrale Konstruktion mit einer verbesserten Temperaturübertragung bereitgestellt werden. Indem die Temperiervorrichtung 10 im zusammengesetzten Zustand eine mechanische Vorspannung aufweist, ist eine kontinuierliche, zweiseitige Flächenpressung zur Ankopplung des ersten Heizelementes bzw. Temperierelementes 20 verfügbar. Ferner kann eine Ankopplung der Unterseite 14.6 des Unterteils 14 an eine externe Untergrundfläche bzw. eine zu temperierende Oberfläche sichergestellt werden.

Indem das Unterteil 14 als zentrale Aufnahme für die übrigen Komponenten der Temperiervorrichtung 10 dient, ist eine integrale, bauraumsparende Konstruktion verfügbar. Des Weiteren wirkt das Erdkontaktelement 26 bifunktional, nämlich als Erdungsanschluss und als Wärmeleitelement für den Temperatursensor 28.

Anhand der vorliegenden Erfindung ist somit eine bauraumoptimierte Temperiervorrichtung 10 verfügbar, die auch während einer Temperaturerhöhung eine effiziente Wärmeübertragung sicherstellt.

### Bezugszeichenliste

- 10: Temperiervorrichtung
- 12: Oberteil
- 12.1; 12.1': erstes Verschränkungselement (des Oberteils)
- 12.2; 12.2': zweites Verschränkungselement (des Oberteils)
- 12.3: erstes Spannelement
- 12.4: zweites Spannelement
- 12.5: Ankopplungsfläche (des Oberteils)
- 14: Unterteil
- 14.1; 14.1': erstes Verschränkungselement (des Unterteils)
- 14.2; 14.2': zweites Verschränkungselement (des Unterteils)
- 14.3: erstes Aufnahmeelement (des Unterteils)
- 14.4; 14.4': zweites Aufnahmeelement (des Unterteils)
- 14.5: Ankopplungsfläche (des Unterteils)
- 14.6: Unterseite des Unterteils
- 16: erstes Endkappenelement
- 16a: Oberteil des ersten Endkappenelementes
- 16b: Unterteil des ersten Endkappenelementes
- 16.1: erstes Rastelement
- 16.2: Aufnahmeelement
- 16.3: Zapfenelement
- 18: zweites Endkappenelement
- 18a: Befestigungsspange
- 18b: Grundkörper
- 18c: Nasenelement
- 18.2; 18.2': zweites Rastelement
- 20: erstes Temperierelement/Heizelement
- 20a: Oberseite des ersten Temperierelementes
- 20b: Unterseite des ersten Temperierelementes
- 24.1: erster elektrischer Anschluss
- 24.2: zweiter elektrischer Anschluss
- 26: Erdkontaktelement
- 28: Temperatursensor
- 32: elektrisches Kabel / Anschlusskabel

## Patentansprüche

1. Temperiervorrichtung (10) zur Anordnung an einer zu temperierenden Oberfläche, mit wenigstens einem Oberteil (12), wenigstens einem Unterteil (14) und wenigstens einem ersten Temperierelement (20)
wobei das Oberteil (12) einer Oberseite (20a) des ersten Temperierelementes (20) gegenüberliegend angeordnet ist und das Unterteil (14) einer Unterseite (20b) des ersten Temperierelementes (20) gegenüberliegend angeordnet ist,
wobei das Unterteil (14) und das Oberteil (12) derart ausgebildet und miteinander im Eingriff sind, sodass mit dem Oberteil (12) und dem Unterteil (14) eine Flächenpressung auf die Oberseite (20a) und die Unterseite (20b) des ersten Temperierelementes (20) bereitgestellt ist und das Unterteil (14) an die zu temperierende Oberfläche flächenmäßig ankoppelbar ist, wobei die Temperiervorrichtung (10) ein erstes Endkappenelement (16) und ein zweites Endkappenelement (18) aufweist,
wobei das Oberteil (12), das erste Endkappenelement (16) und das zweite Endkappenelement (18) jeweils an dem Unterteil (14) angeordnet sind,
**dadurch gekennzeichnet, dass**
das zweite Endkappenelement (18) einen Grundkörper (18b) und eine Befestigungsspange (18a) zur Fixierung des Grundkörpers (18b) an der zu temperierenden Oberfläche aufweist,
wobei die Befestigungsspange (18a) in einer Ausnehmung des Grundkörpers (18b) derart angeordnet ist, dass eine Längenänderung der Temperiervorrichtung (10) mittels einer elastischen Verformung der Befestigungsspange (18a) kompensierbar ist.

2. Temperiervorrichtung (10) nach Anspruch 1,
**dadurch gekennzeichnet, dass**
das Oberteil (12) wenigstens ein erstes Spannelement (12.3; 12.4) aufweist, das sich in Längsrichtung des Oberteils (12) erstreckt, sodass das Oberteil (12) beim Ineinandergreifen mit dem Unterteil (14) eine Vorspannung bereitstellt, insbesondere über die gesamte Erstreckung des Unterteils (14).

3. Temperiervorrichtung (10) nach einem der vorhergehenden Ansprüche,
**dadurch gekennzeichnet, dass**
das Oberteil (12) eine Oberflächenstruktur aufweist, insbesondere eine rippenförmige Oberflächenstruktur.

4. Temperiervorrichtung (10) nach einem der vorhergehenden Ansprüche,
**dadurch gekennzeichnet, dass**
die Temperiervorrichtung (10) ein Erdkontaktelement (26) aufweist, welches mit der Unterseite (20b) des ersten Temperierelementes (20) verbindbar ist, sodass eine Ankopplung, insbesondere eine elektrisch-thermische Ankopplung, an das erste Temperierelement (20) und das Unterteil (14) bereitstellbar ist.

5. Temperiervorrichtung (10) nach Anspruch 4,
**dadurch gekennzeichnet, dass**
die Temperiervorrichtung (10) einen Temperatursensor (28) aufweist, der auf dem Erdkontaktelement (26) als einem Wärmeleitelement angeordnet ist.

6. Temperiervorrichtung (10) nach einem der vorhergehenden Ansprüche,
**dadurch gekennzeichnet, dass**
an Seitenenden des Oberteils (12) und in Seitenendbereichen des Unterteils (14) zueinander korrespondierend ausgestaltete erste und zweite Verschränkungselemente (12.1; 12.1'; 12.2; 12.2'; 14.1; 14.1'; 14.2; 14.2') vorgesehen sind, die sich in Längsrichtung des Oberteils (12) und in Längsrichtung des Unterteils (14) erstrecken, sodass das Oberteil (12) und das Unterteil (14) kraft- und/oder formschlüssig miteinander verbindbar sind.

7. Temperiervorrichtung (10) nach einem der vorhergehenden Ansprüche,
**dadurch gekennzeichnet, dass**
das Oberteil (12) und das Unterteil (14) zwischen dem ersten und zweiten Endkappenelement (16; 18) angeordnet sind, zur Ausbildung eines Gehäuses für das erste Temperierelement (20).

8. Temperiervorrichtung (10) nach einem der vorhergehenden Ansprüche,
**dadurch gekennzeichnet, dass**
das erste Endkappenelement (16) wenigstens ein erstes Rastelement (16.1) aufweist, das zweite Endkappenelement (18) wenigstens ein zweites Rastelement (18.2; 18.2') aufweist und das Unterteil (14) wenigstens ein erstes Aufnahmeelement (14.3) und wenigstens ein zweites Aufnahmeelement (14.4; 14.4') aufweist,
wobei das erste und zweite Rastelement (16.1; 18.2; 18.2') jeweils korrespondierend zu dem ersten und zweiten Aufnahmeelement (14.3; 14.4; 14.4') ausgebildet sind, zur kraft- und/oder formschlüssigen Verbindung des Unterteils (14) mit dem ersten und zweiten Endkappenelement (16; 18).

9. Temperiervorrichtung (10) nach einem der vorhergehenden Ansprüche,
**dadurch gekennzeichnet, dass**
entlang der Ausnehmung des Grundkörpers (18b) wenigstens ein Nasenelement (18c) ausgebildet ist, zur Übertragung einer Spannkraft zwischen dem Grundkörper (18b) und der Befestigungsspange (18a) in Längsrichtung der Temperiervorrichtung (10).

10. System, insbesondere einen Schaltschrank oder ein Elektronikgehäuse, mit einer Temperiervorrichtung (10) gemäß einem der vorhergehenden Ansprüche.

## Claims

1. A tempering device (10) for being arranged on a surface to be tempered, having at least one upper part (12), at least one lower part (14) and at least one first tempering element (20), wherein the upper part (12) is arranged opposite an upper side (20a) of the first tempering element (20), and the lower part (14) is arranged opposite a lower side (20b) of the first tempering element (20),
wherein the lower part (14) and the upper part (12) are formed in a manner and in engagement with one another such that a surface pressure onto the upper side (20a) and the lower side (20b) of the first tempering element (20) is provided by means of the upper part (12) and the lower part (14), and the lower part (14) is dimensionally couplable to the surface to be tempered,
wherein the tempering device (10) has a first end cap element (16) and a second end cap element (18),
wherein the upper part (12), the first end cap element (16) and the second end cap element (18) each are arranged at the lower part (14),
**characterized in that**
the second end cap element (18) has a base body (18b) and a fixing clamp (18a) for fixing the base body (18b) to the surface to be tempered,
wherein the fixing clamp (18a) is arranged within a recess of the base body (18b) such that a change in length of the tempering device (10) is compensable by means of an elastic deformation of the fixing clamp (18a).

2. The tempering device (10) according to claim 1,
**characterized in that**
the upper part (12) has at least one first tensioning element (12,3; 12,4) extending in the longitudinal direction of the upper part (12) such that the upper part (12) when engaging with the lower part (14) provides a pretension in particular over the entire extension of the lower part (14).

3. The tempering device (10) according to any one of the preceding claims,
**characterized in that**
the upper part (12) has a surface structure, in particular a rib-shaped surface structure.

4. The tempering device (10) according to any one of the preceding claims,
**characterized in that**
the tempering device (10) has a ground contact element (26) which is connectable to the lower side (20b) of the first tempering element (20) such that a coupling, in particular an electrical-thermal coupling to the first tempering element (20) and the lower part (14) is providable.

5. The tempering device (10) according to claim 4,
**characterized in that**
the tempering device (10) has a temperature sensor (28) arranged on the ground contact element (26) as a heat conducting element.

6. The tempering device (10) according to any one of the preceding claims,
**characterized in that**
at side ends of the upper part (12) and in side end areas of the lower part (14), first and second entanglement elements (12.1; 12.1'; 12.2; 12.2'; 14.1; 14.1'; 14.2; 14.2') formed to be corresponding to one another are provided extending in the longitudinal direction of the upper part (12) and in the longitudinal direction of the lower part (14), such that the upper part (12) and the lower part (14) are connectable in a force-fit or form-fit manner.

7. The tempering device (10) according to any one of the preceding claims,
**characterized in that**
the upper part (12) and the lower part (14) are arranged between the first and the second end cap element (16; 18) for forming a housing for the first tempering element (20).

8. The tempering device (10) according to any one of the preceding claims,
**characterized in that**
the first end cap element (16) has at least one first latching element (16.1), the second end cap element (18) has at least one second latching element (18.2; 18.2'), and the lower part (14) has at least one first receiving element (14.3) and at least one second receiving element (14.4; 14.4'),
wherein the first and the second latching element (16.1; 18.2; 18.2') each are formed corresponding to the first and the second receiving element (14.3; 14.4; 14.4') for the force-fit and/or form-fit connection of the lower part (14) to the first and second end cap element (16; 18).

9. The tempering device (10) according to any one of the preceding claims,
**characterized in that**
along the recess of the base body (18b), at least one nose element (18c) is formed for transmitting a tension force between the base body (18b) and the fixing clamp (18a) in the longitudinal direction of the tempering device (10).

10. A system, in particular a control cabinet or an electronic housing, including a tempering device (10) according to any one of the preceding claims.

## Revendications

1. Dispositif de mise en température (10) destiné à être disposé au niveau d'une surface à mettre en température, présentant au moins une partie supérieure (12), au moins une partie inférieure (14) et au moins un premier élément de mise en température (20),
sachant que la partie supérieure (12) est disposée à l'opposé d'un côté supérieur (20a) du premier élément de mise en température (20) et la partie inférieure (14) est disposée à l'opposé d'un côté inférieur (20b) du premier élément de mise en température (20),
sachant que la partie inférieure (14) et la partie supérieure (12) sont constituées et en prise l'une avec l'autre de telle manière qu'avec la partie supérieure (12) et la partie inférieure (14), une compression de surface est assurée sur le côté supérieur (20a) et le côté inférieur (20b) du premier élément de mise en température (20), et la partie inférieure (14) est apte à être couplée surfaciquement à la surface à mettre en température,
sachant que le dispositif de mise en température (10) présente un premier élément de capuchon d'extrémité (16) et un deuxième élément de capuchon d'extrémité (18),
sachant que la partie supérieure (12), le premier élément de capuchon d'extrémité (16) et le deuxième élément de capuchon d'extrémité (18) sont disposés respectivement au niveau de la partie inférieure (14),
**caractérisé en ce que**
le deuxième élément de capuchon d'extrémité (18) présente un corps de base (18b) et une agrafe de fixation (18a) destinée à arrêter le corps de base (18b) au niveau de la surface à mettre en température,
sachant que l'agrafe de fixation (18a) est disposée dans un évidement du corps de base (18b) de telle manière qu'une modification de longueur du dispositif de mise en température (10) puisse être compensée moyennant une déformation élastique de l'agrafe de fixation (18a).

2. Dispositif de mise en température (10) selon la revendication 1,
**caractérisé en ce que**
la partie supérieure (12) présente au moins un premier élément de serrage (12.3 ; 12.4) qui s'étend en direction longitudinale de la partie supérieure (12) de telle sorte que la partie supérieure (12) assure une précontrainte lors de la mise en prise avec la partie inférieure (14), en particulier sur toute l'extension de la partie inférieure (14).

3. Dispositif de mise en température (10) selon l'une des revendications précédentes,
**caractérisé en ce que**
la partie supérieure (12) présente une structure de surface, en particulier une structure de surface en forme de nervures.

4. Dispositif de mise en température (10) selon l'une des revendications précédentes,
**caractérisé en ce que**
le dispositif de mise en température (10) présente un élément de contact de terre (26), lequel peut être relié au côté inférieur (20b) du premier élément de mise en température (20) de telle sorte qu'un couplage, en particulier un couplage électrique-thermique, au premier élément de mise en température (20) et au côté inférieur (14) puisse être assuré.

5. Dispositif de mise en température (10) selon la revendication 4,
**caractérisé en ce que**
le dispositif de mise en température (10) présente un capteur de température (28) qui est disposé sur l'élément de contact de terre (26) comme élément conducteur de chaleur.

6. Dispositif de mise en température (10) selon l'une des revendications précédentes,
**caractérisé en ce que**
un premier et un deuxième élément d'emboîtement (12.1 ; 12.1' ; 12.2 ; 12.2' ; 14.1 ; 14.1' ; 14.2 ; 14.2') configurés de manière correspondante l'un à l'autre au niveau d'extrémités latérales de la partie supérieure (12) et dans des zones d'extrémité latérale de la partie inférieure (14) sont prévus, lesquels s'étendent en direction longitudinale de la partie supérieure (12) et en direction longitudinale de la partie inférieure (14) de telle sorte que la partie supérieure (12) et la partie inférieure (14) puissent reliées l'une à l'autre par adhérence et/ou par complémentarité de forme.

7. Dispositif de mise en température (10) selon l'une des revendications précédentes,
**caractérisé en ce que**
la partie supérieure (12) et la partie inférieure (14) sont disposées entre le premier et le deuxième élément de capuchon d'extrémité (16 ; 18), pour constituer un boîtier pour le premier élément de mise en température (20).

8. Dispositif de mise en température (10) selon l'une des revendications précédentes,
**caractérisé en ce que**
le premier élément de capuchon d'extrémité (16) présente au moins un premier élément d'encliquetage (16.1), le deuxième élément de capuchon d'extrémité (18) présente au moins un deuxième élément d'encliquetage (18.2 ; 18.2') et la partie inférieure (14) présente au moins un premier élément de logement (14.3) et au moins un deuxième élément de logement (14.4 ; 14.4'),
sachant que le premier et le deuxième élément d'encliquetage (16.1 ; 18.2 ; 18.2') sont constitués respectivement de manière correspondante au premier et au deuxième élément de logement (14.3 ; 14.4 ; 14.4'), pour la liaison par adhérence et/ou par complémentarité de forme de la partie inférieure (14) avec le premier et le deuxième élément de capuchon d'extrémité (16 ; 18).

9. Dispositif de mise en température (10) selon l'une des revendications précédentes,
**caractérisé en ce que**
le long de l'évidement du corps de base (18b), au moins un élément d'ergot (18c) est constitué, pour la transmission d'une force de serrage entre le corps de base (18b) et l'agrafe de fixation (18a) en direction longitudinale du dispositif de mise en température (10).

10. Système, en particulier une armoire de distribution ou un boîtier électronique, comportant un dispositif de mise en température (10) selon l'une des revendications précédentes.
